# EUROPÄISCHE PATENTSCHRIFT

(11) **EP 4 252 014 B1**
(45) Veröffentlichungstag und Bekanntmachung des Hinweises auf die Patenterteilung: **08.05.2024**
(21) Anmeldenummer: 21819450.4
(22) Anmeldetag: 25.11.2021
(51) Int. Cl.: G01R 27/18, G01R 31/42, H02H 3/16, H02S 50/10

(54) **ÜBERWACHUNGSVORRICHTUNG FÜR DEN NETZERSATZBETRIEB**
MONITORING DEVICE FOR NETWORK REPLACEMENT OPERATION
DISPOSITIF DE SURVEILLANCE DESTINÉ AU FONCTIONNEMENT DE RÉSEAU DE SUBSTITUTION

(30) Priorität: 26.11.2020 EP 20210023
(43) Veröffentlichungstag der Anmeldung: 04.10.2023
(73) Patentinhaber: FRONIUS INTERNATIONAL GmbH, 4643 Pettenbach (AT)
(72) Erfinder: JUNGREITHMAIR, Roland, 4600 Wels-Thalheim (AT); WIESER, Stefan, 4600 Wels-Thalheim (AT); WOLF, Martin, 4600 Wels-Thalheim (AT); DOPPELBAUER, Bernhard, 4600 Wels-Thalheim (AT)
(74) Vertreter: Patentanwälte Pinter & Weiss OG
(86) Internationale Anmeldenummer: PCT/EP2021/082950
(87) Internationale Veröffentlichungsnummer: WO 2022/112393

(56) Entgegenhaltungen:
- EP-A1- 2 256 506
- EP-A1- 3 620 800
- DE-A1-102014 109 513
- DE-A1-102016 103 883

## Beschreibung

Die gegenständliche Erfindung betrifft ein Verfahren zur Bestimmung eines AC-Isolationswiderstands zwischen den AC-Anschlüssen eines Wechselrichters und einem Erdpotential, wobei an DC-Anschlüssen des Wechselrichters eine DC-Spannung anliegt und zwischen AC-Anschlüssen des Wechselrichters eine AC-Spannung anliegt, wobei die DC-Anschlüsse mit einer DC-Energiequelle verbunden sind und wobei in einem Netzersatzbetrieb die AC-Anschlüsse mit einer AC-Energiesenke verbunden sind, um Energie von der DC-Energiequelle an die AC-Energiesenke zu übertragen. Weiters betrifft die gegenständliche Erfindung eine Überwachungsvorrichtung zur Ermittlung eines AC-Isolationswiderstands zwischen AC-Anschlüssen des Wechselrichters und einem Erdpotential, wobei DC-Anschlüsse des Wechselrichters mit einer DC-Energiequelle verbindbar sind und in einem Netzersatzbetrieb AC-Anschlüsse des Wechselrichters mit einer AC-Energiesenke verbindbar sind, wobei die Überwachungsvorrichtung eine Fehlerstromermittlungseinheit umfasst, welche ausgestaltet ist, aus einer zwischen einem der Zwischenkreis-Anschlüsse und dem Erdpotential oder einem Zwischenkreis-Mittelpunkt und dem Erdpotential anliegenden Isolationsspannung, vorzugsweise dem Wechselspannungsanteil der Isolationsspannung, und einer zwischen dem Zwischenkreis-Anschluss und dem Erdpotential oder dem Zwischenkreis-Mittelpunkt und dem Erdpotential befindlichen Isolationsimpedanz einen zwischen einem AC-Anschluss und einem Erdpotential fließenden AC-Fehlerstrom zu ermitteln, und einen Wechselrichter mit einer Überwachungseinheit.

Ein Wechselrichter, auch Inverter genannt, stellt einen Gleichstrom/Wechselstrom-Wandler dar und wandelt somit eine an einer Eingangsseite zwischen DC-Anschlüssen anliegende Eingangsgleichspannung (DC-Spannung) in eine oder mehrere an einer Ausgangsseite zwischen AC-Anschlüssen anliegende Ausgangswechselspannungen (AC-Spannung). Die DC-Anschlüsse des Wechselrichters sind mit einer Gleichspannungs-Energiequelle (DC-Energiequelle), beispielsweise einer Photovoltaik-Anlage im Generatorbetrieb verbunden. Die DC-Energiequelle stellt die DC-Spannung zur Verfügung und versorgt den Wechselrichter mit Energie. In einem Netzbetrieb sind die AC-Anschlüsse des Wechselrichters mit einem Energieversorgungsnetz verbunden, um die von der DC-Energiequelle zur Verfügung gestellte Energie in das Energieversorgungsnetz einzuspeisen. Vorteilhafterweise sind die AC-Spannungen auf die Netzspannungen des Energieversorgungsnetzes synchronisiert. Ist der Wechselrichter beispielsweise dreiphasig ausgeführt, so ist pro Phase ein AC-Anschluss vorgesehen, und jeweils mit einer Netzphase des Energieversorgungsnetzes verbunden, wobei auch ein Neutralleiter als AC-Anschluss herausgeführt sein kann.

In einem Netzersatzbetreib sind die AC-Anschlüsse des Wechselrichters jedoch vom Energieversorgungsnetz getrennt und stattdessen mit einer Wechselspannungs-Energiesenke (AC-Energiesenke) verbunden, womit die von der DC-Energiequelle zur Verfügung gestellte Energie vom Wechselrichter an die AC-Energiesenke abgegeben wird. Die Trennung der AC-Anschlüsse vom Energieversorgungsnetz erfolgt allpolig und kann sowohl intern im Wechselrichter als auch extern erfolgen. Es ist im Netzersatzbetrieb auch möglich einen mehrphasigen Wechselrichter in einem Einphasenbetrieb zu betreiben. Um einen Einphasenbetreib zu realisieren, können beispielsweise nur zwei der drei Phasenzweige betrieben werden, wobei die einphasige Ausgangswechselspannung zwischen zwei der vier AC-Anschlüsse (drei Phasen und ein Neutralleiter) ausgegeben wird.

Im Energieversorgungsnetz ist eine Netzschutzeinrichtung vorgesehen, wobei Fehlerstromschutzschalter, Sicherungen etc. vorgesehen sein können. Da die Netzschutzeinrichtung netzseitig angeordnet ist, ist sie nur im Netzbetrieb wirksam, nicht jedoch im Netzersatzbetrieb, da alle AC-Anschlüsse vom Energieversorgungsnetz getrennt sind.

Für Wechselrichter ist es demnach in vielen Fällen erforderlich, Schutzeinrichtungen vorzusehen, die den Wechselrichter und insbesondere deren AC-Anschlüsse im Netzersatzbetrieb schützen und/oder Überwachen, wenn nicht im Rahmen eines Netzbetriebes auf Schutzeinrichtungen des Energieversorgungsnetzes zurückgegriffen werden kann. Dem Stand der Technik dahingehend nur teilweise geeignete Überlegungen entnommen werden.

So beschreibt die DE 102014109513 A1 ein Verfahren und eine Vorrichtung zum Überwachen eines elektrischen Kraftstromkreises, der allerdings Bestandteil eines Fahrzeuges und nicht eines Wechselrichters ist. Auf die Besonderheiten von Wechselrichtern wird in der DE 102014109513 A1 demnach nicht eingegangen.

Weiters hat die DE 102016103883 A1 eine DC-Busleckstromerfassung für einen DC-Bus in einem Elektrofahrzeug zum Gegenstand. Definitionsgemäß befasst sich die DE 102016103883 A1 mit elektrischen Gleichgrößen, was jedoch eine Betrachtung von AC-Anschlüssen nicht miteinschließt.

Die EP 2256506 A1 und die EP 3620800 A1 offenbaren darüber hinaus Ansätze zur Überwachung von gesamten, nicht abgeschlossenen Stromnetzen, die sich ebenso nur eingeschränkt auf ein abgeschlossenes System, bestehend aus einem Wechselrichter und einer AC-Senke, übertragen lassen.

Es ist daher eine Aufgabe der gegenständlichen Erfindung, eine Schutzeinrichtung für einen Wechselrichter anzugeben, welche im Netzersatzbetrieb funktionsfähig ist.

Diese Aufgabe wird erfindungsgemäß durch die Merkmale des unabhängigen Anspruchs 1 gelöst.

In einer bevorzugten Weise kann zur Berechnung des AC-Isolationswiderstandes eine mit dem AC-Isolationswiderstand korrespondierende elektrische Spannung des Wechselrichters herangezogen werden, und der AC-Isolationswiderstand aus dem AC-Fehlerstrom und der mit dem AC-Isolationswiderstand korrespondierenden elektrischen Spannung berechnet werden, wie dies aus der Elektrotechnik hinlänglich bekannt ist. Eine derartige elektrische Spannung kann wie eingangs beschrieben eine an einer Ausgangsseite zwischen AC-Anschlüssen des Wechselrichters anliegende Ausgangswechselspannung (AC-Spannung) sein. "Mit dem AC-Isolationswiderstand korrespondierend" ist hierbei so zu verstehen, dass die genannte elektrische Spannung die Berechnung des AC-Isolationswiderstandes erlaubt.

Neben einer an einer Ausgangsseite zwischen AC-Anschlüssen eines Wechselrichters anliegenden AC-Spannung kann zur Berechnung des AC-Isolationswiderstandes auch eine elektrische Spannung herangezogen werden, die mit einer solchen zwischen AC-Anschlüssen eines Wechselrichters anliegenden AC-Spannung in Zusammenhang steht, beispielsweise in dem Sinne, dass die AC-Spannung, die zwischen den zwischen AC-Anschlüssen des Wechselrichters anliegt, aus dieser elektrischen Spannung ermittelt werden kann. Das kann beispielsweise eine zwischen einem AC-Anschluss eines Wechselrichters und dem Erdpotential abfallende elektrische Spannung sein. Fällt die zur Berechnung des AC-Isolationswiderstandes herangezogene elektrische Spannung über dem AC-Isolationswiderstand ab, kann im einfachsten Fall auch das ohmsche Gesetz zur Berechnung des AC-Isolationswiderstandes aus dem AC-Fehlerstrom und der entsprechenden elektrischen Spannung herangezogen werden.

Weiters wird die Aufgabe durch eine Überwachungsvorrichtung gemäß Anspruch 8 gelöst. In einer bevorzugten Weise kann die Berechnungseinheit dabei entsprechend den obigen Ausführungen eine elektrische Spannung wie eine AC-Spannung heranziehen, sodass der AC-Isolationswiderstand aus dem AC-Fehlerstrom und der AC-Spannung berechnet wird. Somit ist es möglich den AC-Isolationswiderstand im laufenden Betrieb des Wechselrichters zu überwachen. Dabei wird der AC-Fehlerstroms herangezogen, welcher auftritt, wenn der AC-Isolationswiderstand zwischen einem AC-Anschluss und dem Erdpotential gering ist, d.h. ein AC-Isolationsfehler vorliegt. Tritt kein Isolationsfehler im Wechselrichter auf, so ist ein hoher AC-Isolationswiderstand zwischen dem AC-Anschluss und dem Erdpotential vorhanden, womit nur ein geringer und vernachlässigbarer AC-Fehlerstrom zwischen dem AC-Anschluss und dem Erdpotential fließt. Es kann angenommen werden, dass der AC-Isolationswiderstand gegen Unendlich strebt. Tritt jedoch ein Isolationsfehler auf, so ist der AC-Isolationswiderstand gering und es fließt ein hoher AC-Fehlerstrom zwischen dem AC-Anschluss und dem Erdpotential. Es kann also ein Isolationsfehler, d.h. ein verringerter AC-Isolationswiderstand, durch den ermittelten AC-Fehlerstrom erkannt werden.

Die Überwachungseinheit kann integraler Bestandteil des Wechselrichters, oder auch separat ausgeführt, sein. Der Wechselrichter und die AC-Energiesenke bilden im Netzersatzbetreib (auch Inselbetrieb genannt) ein IT (Isolé Terre)-System aus. Ein IT-System ist nicht geerdet, womit im Gegensatz zu einem TN-Netz am AC-Anschluss auf einen Fehlerstromschutzschalter und/oder eine Allstrommesseinheit verzichtet werden, um Kosten zu sparen. Erfindungsgemäß wird im Netzersatzbetrieb der AC-Isolationswiderstand zwischen einem AC-Anschluss und dem Erdpotential aktiv überwacht. Passive Messprinzipien sind dem gegenüber nachteilig, da symmetrische Fehler auf einem AC-Anschluss oder Isolationsfehler auf einem DC-Anschluss nicht erkannt werden können. Würde beispielsweise an einem einphasigen Netzersatzbetrieb eine Phase und der Neutralleiter den gleichen Isolationsfehler gegen das Erdpotential aufweisen, so könnte eine passive Spannungsmessung dieser Phase gegen das Erdpotential und das Potential des Neutralleiters entsprechend dem Stand der Technik den Fehler nicht feststellen, da es zu keiner Verschiebung kommen würde.

Erfindungsgemäß wird der AC-Fehlerstrom aus einer zwischen einem Zwischenkreis-Anschluss und dem Erdpotential anliegenden Isolationsspannung, welche mittels einer Spannungsmesseinheit ermittelt werden kann, und einer zwischen dem einen Zwischenkreis-Anschluss und dem Erdpotential befindlichen Isolationsimpedanz berechnet. Die Isolationsimpedanz kann dabei vorab bekannt sein. Es kann der AC-Fehlerstrom auch aus einer zwischen einem Zwischenkreis-Mittelpunkt des Wechselrichters und dem Erdpotential anliegenden Isolationsspannung und einer zwischen dem Zwischenkreis-Mittelpunkt und dem Erdpotential befindlichen Isolationsimpedanz berechnet werden. Je nach Aufbau des Wechselrichters kann auch ein Neutralleiter direkt mit dem Zwischenkreismittelpunkt des Wechselrichters verbunden. Die Isolationsspannung kann sowohl Gleichspannungsanteile als auch Wechselspannungsanteile umfassen.

Dazu kann die Fehlerstromermittlungseinheit ausgestaltet sein, den AC-Fehlerstrom aus einer Isolationsspannung, welche zwischen einem Zwischenkreis-Anschluss und einem Erdpotential oder zwischen einem Zwischenkreis-Mittelpunkt und dem Erdpotential anliegt und einer Isolationsimpedanz, welche zwischen dem Zwischenkreis-Anschluss und dem Erdpotential oder zwischen einem Zwischenkreis-Mittelpunkt und dem Erdpotential befindlich ist zu berechnen.

Der Isolationstest kann mehrfach, vorzugsweise zyklisch mit einer Testtaktrate, besonders vorzugsweise mit einer Testtaktrate im Sekundenbereich, wiederholt werden. Damit kann mit der Testtaktrate überprüft werden, ob ein AC-Fehlerstrom fließt und auf einen Isolationsfehler geschlossen werden.

Vorzugsweise ist eine Spannungsmesseinheit vorgesehen, welche ausgestaltet ist, eine zwischen einem Zwischenkreis-Anschluss und dem Erdpotential oder zwischen dem Zwischenkreis-Mittelpunkt und dem Erdpotential anliegende Isolationsspannung zu messen, wobei die Fehlerstromermittlungseinheit ausgestaltet ist, den AC-Fehlerstrom aus der Isolationsspannung und einer zwischen dem Zwischenkreis-Anschluss und dem Erdpotential oder zwischen dem Zwischenkreis-Mittelpunkt und dem Erdpotential befindlichen Isolationsimpedanz zu berechnen.

Es kann die Isolationsimpedanz durch eine parasitäre DC-Kapazität - z.B. eine DC seitige Kapazität eines PV-Generators - oder durch eine parasitäre DC-Kapazität und einen parallelen DC-Isolationswiderstand angenähert werden.

Vorteilhafterweise wird während des, vorzugsweise gesamten, Isolationstests ein Testsignal mit einer Testfrequenz größer einer AC-Frequenz der AC-Spannung auf die AC-Spannung aufgeschaltet. Vorteilhafterweise hat das Testsignal eine Amplitude von maximal 120V. Es kann eine Fehlerstromschwelle von 10 mA und/oder eine AC-Isolationswiderstandsschwelle von 50 Ohm/Volt vorgesehen sein. Ist kein Testsignal vorgesehen, so kann die AC-Frequenz der AC-Spannung für den Isolationstest verwendet werden.

Vorzugsweise wird innerhalb von 10 Sekunden nach Auftreten eines Isolationsfehlers ein Signal ausgegeben, z.B. in Form einer nicht quittierbaren optischen Anzeige.

Der Wechselrichter kann bei Überschreitung einer Fehlerstromschwelle durch den AC-Fehlerstrom und/oder bei Unterschreitung einer Isolationswiderstandsschwelle des AC-Isolationswiderstand in einen Fehlerstrombetrieb geschaltet und/oder zumindest teilweise abgeschaltet werden. Die Isolationswiderstandsschwelle kann derart gewählt werden, dass der AC-Isolationswiderstand innerhalb eines genormten Bereichs liegt. In einem herkömmlichen IT-System bewirkt ein einmalig detektierter Isolationsfehler keine Abschaltung; in Bezug auf einen Wechselrichter kann jedoch eine sofortige Abschaltung in Erwägung gezogen werden.

Vorzugsweise wird ein DC-Isolationsfehler detektiert, indem ein hochohmiger Widerstand zwischen einem der Zwischenkreis-Anschlüsse und das Erdpotential geschaltet wird und ein Gleichspannungsanteil der Isolationsspannung zwischen einem der Zwischenkreis-Anschlüsse und dem Erdpotential vor und nach dem Schalten des hochohmigen Widerstands ermittelt wird. Das Verhältnis der ermittelten Gleichspannungsanteile der Isolationsspannungen zueinander gibt Auskunft über die Höhe des Isolationswiderstandes. Je hochohmiger der Isolationswiderstand ist, desto stärker wird durch das Einschalten des hochohmigen Widerstands das Potential am Zwischenkreis-Anschluss gegen das Erdpotential verschoben. Somit kann, z.B. mittels der Spanungsmesseinheit die Isolationsspannung vor und nach Schließen des Leistungsschalters ermittelt werden und aus den dadurch erhaltenen Messwerten der Isolationsspannung ein an beliebigen Orten auftretender DC-Isolationsfehler erkannt werden. Vorzugsweise wird eine derartige Erkennung eines DC-Isolationsfehlers nicht nur vor dem Einschalten des Wechselrichters, sondern im laufenden Netzersatzbetrieb durchgeführt. Die Bestimmung eines DC-Isolationsfehlers ist besonders vorteilhaft, wenn der Wechselrichter keine galvanische Trennung zwischen den AC-Anschlüssen und den DC-Anschlüssen aufweist. Damit setzt sich ein gesamtheitlicher Isolationswiderstand aus einem AC-Isolationswiderstand und einem DC-Isolationswiderstand zusammen.

Ein zwischen einem Zwischenkreis-Anschluss und dem Erdpotential auftretender DC-Isolationswiderstand kann auch mittels einer DC-Fehlerstrommesseinheit gemessen werden, wobei eine Allstrommesseinheit (RCMU- Residual Current Monitoring Unit) verwendet werden kann. Eine Allstrommesseinheit ermittelt einen Summenstrom über die Zwischenkreis-Anschlüsse und funktioniert somit nach dem Wirkprinzip eines Fehlerstromschutzschalters. Grundlegend kann eine Allstrommesseinheit dazu verwendet werden, um DC-Isolationsfehler zu erkennen, jedoch nur sofern DC-Fehlerströme zwischen den Zwischenkreis-Anschlüssen und dem Erdpotential fließen. Treten allerdings DC-Isolationsfehler an einem Ort auf, welcher im fehlerfreien Fall auf dem Erdpotential liegt, so fließt kein DC-Fehlerstrom, womit der DC-Isolationsfehler unter Verwendung einer Allstrommesseinheit nicht erkannt werden kann.

Es kann ein Netzbetrieb des Wechselrichters vorgesehen sein, wobei beim Schalten vom Netzersatzbetrieb in den Netzbetrieb die AC-Anschlüsse des Wechselrichters von der AC-Energiesenke getrennt und/oder mit einem Energieversorgungsnetz verbunden werden, um Energie von der DC-Energiequelle in das Energieversorgungsnetz zu übertragen. Im Netzbetrieb ist der Isolationstest vorzugsweise ausgesetzt ist. Dies ist besonders vorteilhaft, wenn im Energieversorgungsnetz bereits Schutzmaßnahmen, wie Fehlerstromschutzeinrichtungen, Überstromschutzeinrichtungen usw. implementiert sind.

Die gegenständliche Erfindung wird nachfolgend unter Bezugnahme auf die Figuren 1 bis 5 näher erläutert, die beispielhaft, schematisch und nicht einschränkend vorteilhafte Ausgestaltungen der Erfindung zeigen. Dabei zeigt
- Fig.1: eine Anordnung aus einem Wechselrichter, einer AC-Energiesenke, einer DC-Energiequelle und einer Überwachungsvorrichtung,
- Fig.2: die Anordnung mit einer Fehlerstromermittlungseinheit als Fehlerstrommesseinheit,
- Fig.3: die Anordnung mit einer Spannungsmesseinheit zum Messen einer Isolationsspannung an einer Isolationsimpedanz,
- Fig.4: eine alternative Anordnung zum Messen einer Isolationsimpedanz,
- Fig. 5: Verläufe einer AC-Frequenz, einer Testfrequenz, sowie zugehörigen
Fehlerströmen, Phasenwinkeln, AC-Spannungen, Fehlerstromphasenwinkeln und Isolationswiderständen.

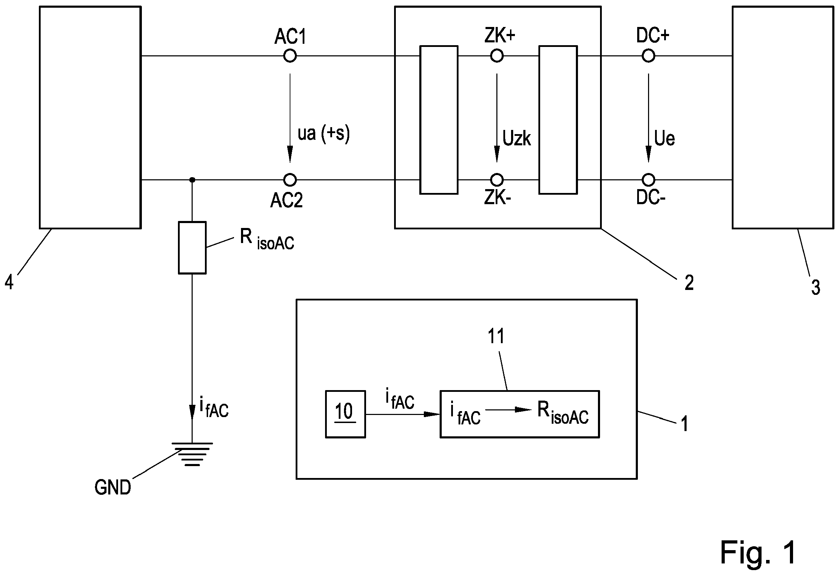

In Fig. 1 ist eine Anordnung aus einem Wechselrichter 2, einer AC-Energiesenke 4 und einer DC-Energiequelle 3 dargestellt. Es sind AC-Anschlüsse AC1, AC2 des Wechselrichters 2 mit der AC-Energiesenke 4 verbunden sowie DC-Anschlüsse DC+, DC- des Wechselrichters 2 mit der DC-Energiequelle 3 verbunden. Die AC-Anschlüsse AC1, AC2 können beispielsweise zwei Phasen des Wechselrichters 2 darstellen. Der Wechselrichter 2 umfasst weiters einen optionalen Zwischenkreis mit Zwischenkreis-Anschlüssen ZK+, ZK-, zwischen welchen eine DC-Zwischenkreisspannung Uzk auftritt.

Es ist auch möglich einen grundlegend mehrphasig, z.B. dreiphasig, ausgeführten Wechselrichter 2 mit einer zweiphasigen AC-Energiesenke 4 zu verbinden, wobei zwei der drei Phasen des Wechselrichters 2 mit der AC-Energiesenke 4 verbunden werden. Es kann auch eine mehrphasige, z.B. dreiphasige AC-Energiesenke 4 mit den AC-Anschlüssen des Wechselrichters 2 verbunden werden, wobei mehrere, z.B. drei, AC-Anschlüsse jeweils durch die Phasen des Wechselrichters 2 ausgebildet werden.

Der Wechselrichter 2 wandelt eine von der DC-Energiequelle 3 zur Verfügung gestellte DC-Eingangsspannung Ue über die DC-Zwischenkreisspannung ZK, ZK- in eine AC-Spannung ua, welche wiederum der AC-Energiesenke 4 zur Verfügung gestellt wird. Damit wird Energie von der DC-Energiequelle 3 an die AC-Energiesenke 4 übertragen. Es liegt die DC-Spannung Ue zwischen den DC-Anschlüssen DC+, DC- an und die AC-Spannung ua zwischen den AC-Anschlüssen AC1, AC2. Als AC-Energiesenke 4 kann z.B. eine elektrische Maschine oder ein anderer elektrischer Verbraucher vorgesehen sein. Als DC-Energiequelle 3 können beispielsweise Batterien/Stromspeicher und/oder Photovoltaikzellen vorgesehen sein.

Sowohl an den DC-Anschlüssen DC+, DC-, als auch an den AC-Anschlüssen AC1, AC2 können jeweils Filterkondensatoren und/oder Filterinduktivitäten vorgesehen sein (nicht in den Figuren dargestellt).

Der Wechselrichter 4 kann auch bidirektional ausgeführt sein, was bedeutet, dass auch eine an den AC-Anschlüssen AC1, AC2 anliegende AC-Spannung ua auf die DC-Zwischenkreisspannung ZK+, ZK- und weiter auf an den DC-Anschlüssen DC+, DCanliegende DC-Eingangsspannung Ue gewandelt werden kann. Damit ist auch ein Energietransport von den AC-Anschlüssen AC1, AC2 zum Zwischenkreis möglich, an welchem beispielsweise ein Stromspeicher/Batterie, welcher PV-Strom direkt verbraucht, verbunden ist. Ein bidirektionaler Wechselrichter 2 wird auch als Hybrid-Wechselrichter bezeichnet. Es können somit auch Verbraucher auch mit getrennten AC-Anschlüssen versorgt werden - also z.B. von dem/der Stromspeicher/Batterie. Die AC-Anschlüsse können mittels eines AC-Trenners geöffnet werden, sodass der Wechselrichter 2 vom Energieversorgungsnetz getrennt wird.

In den Figuren befindet sich der Wechselrichter 2 somit in einem Netzersatzbetrieb NE, da der AC-Trenner geöffnet ist, weshalb das Energieversorgungsnetz und der AC-Trenner zur Vereinfachung nicht dargestellt sind. Wird der Wechselrichter 2 in einen Netzbetrieb geschaltet (nicht dargestellt), dann werden die AC-Anschlüsse AC1, AC2 mit den Netzphasen eines Energieversorgungsnetzes verbunden (geschlossener AC-Trenner) und die AC-Energiesenke 4 kann getrennt werden. Wird der Wechselrichter 2 wieder in den Netzersatzbetrieb NE geschaltet, so werden die AC-Anschlüsse AC1, AC2 von den Netzphasen des Energieversorgungsnetzes getrennt und mit der AC-Energiesenke 4 verbunden. Die Energiesenke 4 kann beispielsweise zumindest eine in den Wechselrichter 2 integrierte Steckdose sein, an welche zumindest ein Verbraucher angeschlossen und versorgt werden kann.

Bei einer derartigen Variante kann also der Wechselrichter 2 im Netzersatzbetrieb NE z.B. jene Verbraucher versorgen, die mit der integrierten Steckdose verbunden sind. Alle weiteren Verbraucher können dabei mit einem AC-Trenner getrennt werden.

In einer weiteren Variante ist es auch möglich, dass die integrierte Steckdose auch während dem Netzbetrieb vom Energieversorgungsnetz versorgt wird. Dabei kann schaltungstechnisch die AC-Energiesenke trotzdem getrennt und sozusagen mit einer Verbindung zum Energieversorgungnetz überbrückt werden.

Im Netzersatzbetrieb NE sind Netzschutzeinrichtungen auf Seiten des Energieversorgungsnetzes wirkungslos, da der Wechselrichter 2 vom Energieversorgungsnetz und damit auch von den Netzschutzeinrichtungen getrennt ist. Vielmehr liegt in Verbindung mit der AC-Energiesenke 4 ein IT-System vor, welches per Definition nicht mit einem Erdpotential GND verbunden ist. Es liegt zwischen den AC-Anschlüssen AC1, AC2 des Wechselrichters 2 und dem Erdpotential GND ein AC-Isolationswiderstand R_{isoAC} vor, wobei erfindungsgemäß eine Überwachungsvorrichtung 1 zur Ermittlung des ohmschen AC-Isolationswiderstands R_{isoAC} vorgesehen ist. Die Überwachungsvorrichtung 1 umfasst eine Fehlerstromermittlungseinheit 10, welche ausgestaltet ist, zur Durchführung eines Isolationstests I einen zwischen einem AC-Anschluss AC1, AC2 und einem Erdpotential GND fließenden AC-Fehlerstrom i_{fAC} zu ermitteln. Eine Berechnungseinheit 11 berechnet unter Verwendung des AC-Fehlerstroms i_{fAC} den AC-Isolationswiderstand R_{isoAC}. Das "AC" im AC-Isolationswiderstand R_{isoAC} bezieht sich auf die AC-Seite des Wechselrichters 2, auf welcher der AC-Isolationswiderstand R_{isoAC} auftritt.

Tritt im Wechselrichter 2 kein Isolationsfehler auf, dann ist der AC-Isolationswiderstand R_{isoAC} hoch. Tritt im Wechselrichter 2 jedoch ein Isolationsfehler auf, so sinkt der AC-Isolationswiderstand R_{isoAC}. Bei einem auftretenden Isolationsfehler ist also der AC-Isolationswiderstand R_{isoAC} niedrig.

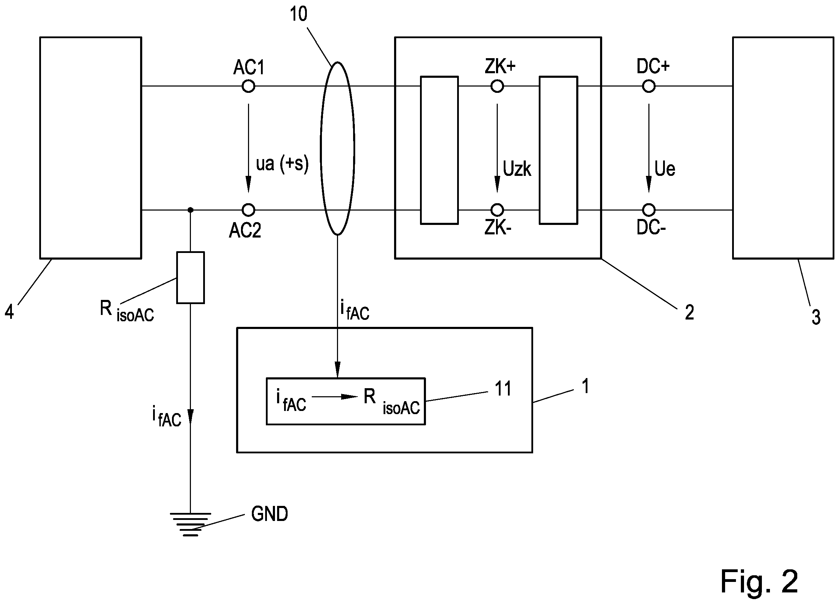

Ist die Fehlerstromermittlungseinheit 10 als Fehlerstrommesseinheit ausgeführt, wie es in Fig. 2 dargestellt ist, so kann zur Durchführung des Isolationstests I der AC-Fehlerstrom i_{fAC} direkt gemessen werden. Als Fehlerstrommesseinheit 10 kann eine Allstrommesseinheiten (engl. RCMU - Residual Current Monitoring Unit) vorgesehen sein, welche die AC-Anschlüsse AC1, AC2 umschließt und einen Summenstrom misst.

Entsprechend kann die Fehlerstromermittlungseinheit 10 und die Berechnungseinheit 11 mit einer nicht dargestellten Steuereinheit/Regeleinheit des Wechselrichters verbunden sein, welche ausgestaltet sind die die Fehlerstromermittlungseinheit 10 und die Berechnungseinheit 11 anzusteuern.

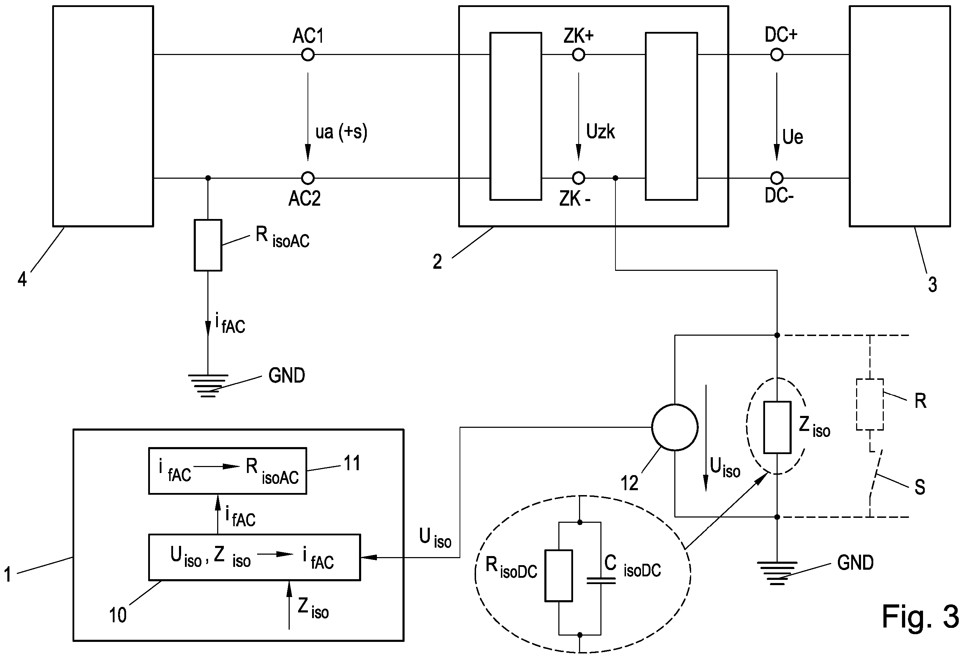

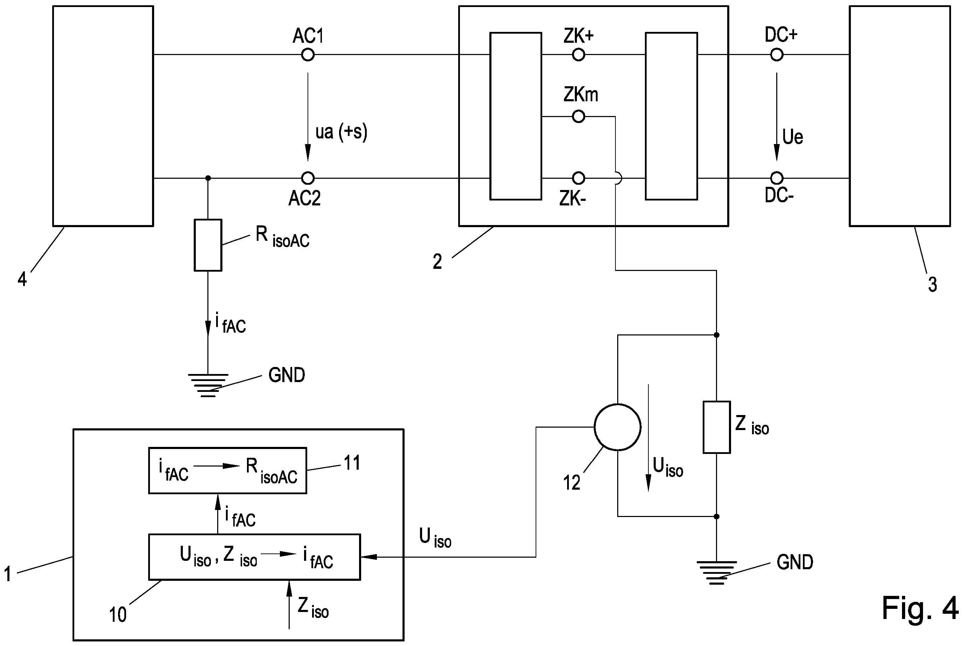

Alternativ oder zusätzlich kann die Fehlerstromermittlungseinheit 10 dazu ausgestaltet sein, zur Durchführung des Isolationstests I den AC-Fehlerstrom i_{fAC} zu berechnen. Hierzu kann zwischen einem der Zwischenkreis-Anschlüsse ZK+, ZK- und einem Erdpotential GND ein Wechselspannungsanteil einer Isolationsspannung Uᵢₛₒ ermittelt werden, wie in Fig. 3 dargestellt. In Zusammenhang mit einer bekannten Isolationsimpedanz Zᵢₛₒ, welche zwischen einem der Zwischenkreis-Anschlüsse ZK+, ZK- und dem Erdpotential GND vorliegt, kann der AC-Fehlerstrom i_{fAC} in der Fehlerstromermittlungseinheit 10 berechnet werden. Aus dem AC-Fehlerstrom i_{fAC} kann dann entsprechend der AC-Isolationswiderstand R_{isoAC} berechnet werden. Es kann, insbesondere in mehrphasigen Wechselrichtern 2, auch ein Wechselspannungsanteil der Isolationsspannung Uᵢₛₒ zwischen einem Zwischenkreis-Mittelpunkt ZKm und einem Erdpotential GND ermittelt werden, wie in Fig. 4 dargestellt. Die Berechnung des AC-Fehlerstroms i_{fAC} kann erfolgen, wie oben bezüglich Fig. 3 beschrieben. Die Isolationsspannung Uᵢₛₒ kann unter Verwendung einer Spannungsmesseinheit 12 ermittelt werden, wie es in Fig. 3 und 4 dargestellt ist. Die Spannungsmesseinheit 12 misst vorzugsweise sowohl einen Gleichspannungsanteil als auch einen Wechselspannungsanteil der Isolationsspannung Uᵢₛₒ
Vorzugsweise wird während des, vorzugsweise gesamten, Isolationstests I ein Testsignal s mit einer Testfrequenz f größer einer AC-Frequenz f_{AC} der AC-Spannung ua auf die AC-Spannung ua aufmoduliert, was in den Fig. 1 bis 4 durch "ua (+s) angedeutet wird. Zur Erzeugung des Testsignals kann eine Testsignalgenerator vorgesehen sein, zur Aufmodulierung des Testsignals auf die AC-Spannung ua kann eine Testsignalkopplungseinheit vorgesehen sein.

Die Isolationsimpedanz Zᵢₛₒ wird vorzugsweise durch eine bekannte parasitäre DC-Kapazität C_{isoDC}, z.B. eine DC-seitige Kapazität einer Gleichspannungsquelle (z.B. ein PV-Generator), angenähert. Die DC-Kapazität C_{isoDC} kann für andere Routinen im Wechselrichter 2 benötigt und entsprechend bevorzugt kontinuierlich ermittelt werden. In diesem Fall kann für die Berechnung des AC-Fehlerstroms i_{fAC} auf die bereits ermittelte DC-Kapazität C_{isoDC} zurückgegriffen werden. Es kann angenommen werden, dass die Isolationsimpedanz Zᵢₛₒ näherungsweise der Reaktanz Xc entspricht, welche durch die parasitäre DC-Kapazität C_{isoDC} bei der AC-Frequenz f_{AC} der AC-Spannung oder bei Verwendung eines Testsignals s bei einer Testfrequenz f des Testsignals s gebildet wird. Es ist auch möglich die Isolationsimpedanz Zᵢₛₒ durch eine bekannte parasitäre DC-Kapazität C_{isoDC} und einen parallelen ohmschen DC-Isolationswiderstand R_{isoDC} anzunähern, wie in Fig. 3 angedeutet. Das "DC" im DC-Isolationswiderstand R_{isoDC} und in der DC-Kapazität C_{isoDC} bezieht sich auf die DC-Seite des Wechselrichters 2, auf welcher der DC-Isolationswiderstand R_{isoDC} und die DC-Kapazität C_{isoDC} auftritt. Insbesondere bei einem kleinen ohmschen DC-Isolationswiderstand R_{isoDC} der Isolationsimpedanz Zᵢₛₒ kann die Isolationsimpedanz Zᵢₛₒ wiederum durch die Reaktanz Xc angenähert werden, da bei einem kleinen bzw. niedrigen DC-Isolationswiderstand R_{isoDC} bereits angenommen werden kann, dass ein DC-Isolationsfehler vorliegt, womit auf eine Berechnung des AC-Isolationswiderstandes R_{isoAC} verzichtet werden kann.

Es kann in beiden Fällen der Betrag und der Phasenwinkel des AC-Fehlerstroms i_{fAC} direkt aus dem Quotienten i_{fAC} = Uᵢₛₒ/Zᵢₛₒ (bei der AC-Frequenz f_{AC}, oder wenn ein Testsignal s verwendet wird bei der Testfrequenz f des Testsignals s) berechnet werden. Für die Berechnung des AC-Fehlerstroms i_{fAC} wird vorzugsweise ein Wechselspannungsanteil der Isolationsspannung Uᵢₛₒ bei der AC-Frequenz f_{AC}, oder wenn ein Testsignal s verwendet wird bei der Testfrequenz f eines Testsignals s, verwendet.

Unabhängig davon, ob der AC-Fehlerstrom gemäß Fig. 2 gemessen oder gemäß den Fig. 1, Fig. 3 und/oder Fig. 4 berechnet wird, dient der AC-Fehlerstrom i_{fAC} als Input für die Berechnungseinheit 11, welche den AC-Isolationswiderstand R_{isoAC} berechnet. Dazu sind folgende Schritte vorgesehen:
In einem nächsten Schritt wird die Phasenabweichung Δϕ zwischen dem AC-Phasenwinkel ϕ_{AC} der AC-Spannung ua (oder des Testsignals s) und dem Fehlerstromphasenwinkel ϕ_{ifAC} des AC-Fehlerstroms i_{fAC} berechnet: Δϕ = ϕ_{AC} - ϕ_{ifAC}. Die Phasenabweichung Δϕ ist also der Abstand der Nulldurchgänge zwischen der AC-Spannung ua (oder des Testsignals s) und dem AC-Fehlerstrom irac. Ist der AC-Spannung ua ein Testsignal s überlagert, so ist aus der resultierenden Spannung ua+s der Anteil mit der Testfrequenz f des Testsignals s relevant.

Aus dem bekannten Zusammenhang tan(ϕ[Z]) = Im[Z]/Re[Z] (Z entspricht Zᵢₛₒ) kann - wie oben erwähnt - bei einem hohen DC-Isolationswiderstand R_{isoDC} näherungsweise die Gleichung tan(Δϕ) = R_{isoAC}/Xc gebildet werden, welche daraufhin nach R_{isoAC} aufgelöst werden kann, womit der AC-Isolationswiderstand R_{isoAC} berechnet werden kann.

Der AC-Isolationswiderstand R_{isoAC} wird dabei vorzugsweise zyklisch berechnet, beispielsweise im Sekundenbereich.

Für die Berechnung des AC-Isolationswiderstands R_{isoAC} kann ebenfalls ein Testsignal s mit einer Testfrequenz f verwendet werden. Die Testfrequenz f, welcher der AC-Frequenz f_{AC} überlagert/aufmoduliert wird, kann dabei der AC-Frequenz f_{AC} der AC-Spannung ua entsprechen, oder bevorzugt einer höheren Frequenz. Das Testsignal s liegt vorzugsweise während des Isolationstests I dauerhaft an.

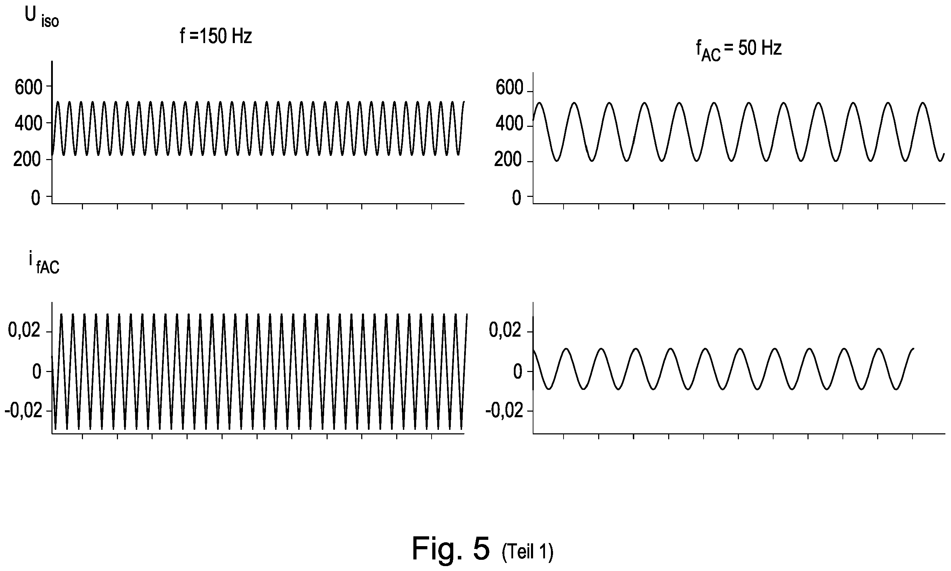

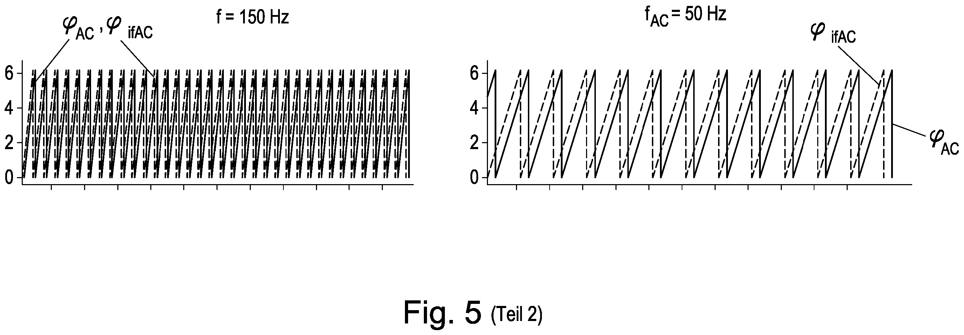

In Fig. 5 sind Messwerte für einen Isolationstest unter Verwendung der AC-Frequenz f_{AC} von 50 Hz (rechts) und unter Verwendung einer Testfrequenz f von 150 Hz (links) gegenübergestellt.

Der oberste Graph zeigt einen Wechselspannungsanteil der Isolationsspannung Uᵢₛₒ mit der AC-Frequenz f_{AC} und der Testfrequenz f; im darunterliegenden Graph ist der AC-Fehlerstrom i_{fAC} mit der mit der AC-Frequenz f_{AC} und der Testfrequenz f zu sehen. Es ist ersichtlich, dass der Fehlerstrom i_{fAC} (bzw. dessen Amplitude) bei Verwendung eines Testsignals s mit einer Testfrequenz f größer der AC-Frequenz f_{AC} (also hier 150 Hz > 50 Hz) höher ist, als der Fehlerstrom i_{fAC} bei Verwendung der AC-Frequenz f_{AC} entspricht.

Weiters sind in Fig. 5 links der AC-Phasenwinkel ϕ_{AC} des Testsignal s und der zugehörige Fehlerstromphasenwinkel ϕ_{ifAC} (strichliert) dargestellt und in Fig. 5 rechts der AC-Phasenwinkel ϕ_{ifAC} der AC-Spannung und der zugehörige Fehlerstromphasenwinkel (strichliert) ϕ_{lfAC} dargestellt Es ist also ersichtlich, dass der Fehlerstromphasenwinkel ϕ_{ifAC} bei der AC-Frequenz f vom Fehlerstromphasenwinkel ϕ_{ifAC} bei der Testfrequenz f abweicht. Während eines Isolationstests I wird ein AC-Isolationswiderstand R_{isoAC} berechnet, was vorzugsweise zyklisch mit einer Testtaktrate, wiederholt wird. Die Testtaktrate kann im Sekundenbereich angesiedelt sein, und z.B. 1 bis 5, vorzugsweise 3, Sekunden, was bedeutet, dass der Isolationstest I alle 1 bis 5, vorzugsweise alle 3, Sekunden wiederholt wird. Ist der aus der Phasenabweichung Δϕ zwischen dem AC-Phasenwinkel ϕ_{AC} der AC-Spannung ua (oder des Testsignals s) und dem Fehlerstromphasenwinkel ϕ_{ifAC} berechnete AC-Isolationswiderstand R_{isoAC} unter einer vorgegebenen Isolationswiderstandssschwelle, so liegt ein AC-Isolationsfehler vor.

Da die Reaktanz Xc der DC-Kapazität C_{isoDC} mit der Frequenz steigt, steigt der AC-Fehlerstrom i_{fAC} ebenso mit steigender Frequenz (siehe Fig. 5, i_{fAC}), womit sich ein Einfluss einer ggf. schwankenden parasitären DC-Kapazität C_{isoDC} kompensieren lässt. Die Messung eines Wechselspannungsanteils der Isolationsspannung Uᵢₛₒ wird durch eine erhöhte Frequenz (was hier anhand der Testfrequenz f=150Hz gegenüber der AC-Frequenz f gezeigt wird) nicht oder nur geringfügig beeinflusst, da zwar der Strom steigt, jedoch die Reaktanz X_{C} im selben Ausmaß sinkt.

Da der Wechselrichter 4 über keine galvanische Trennung zwischen den AC-Anschlüssen und den DC-Anschlüssen verfügt, kann zusätzlich auch ein DC-Isolationsfehler detektiert werden. Dies kann mittels der Fehlerstromermittlungseinheit 10 (beispielsweise eine Allstrommesseinheit RCMU gemäß Fig. 2), welche sowohl einen Wechselspannungsanteil als auch den Gleichspannungsanteil des Fehlerstroms i_{fAC} misst, erfolgen. Eine Allstrommesseinheit eignet sich besonders zur Detektion sprunghafter auftretender DC-Isolationsfehler.

Allgemein kann ein DC-Isolationsfehler aber auch derart detektiert werden, indem mittels eines Testschalters S ein hochohmiger Widerstand R zwischen einen der Zwischenkreis-Anschlüsse ZK+, ZK- und das Erdpotential GND geschaltet wird, wie in Fig. 3 strichliert dargestellt und ebenso für die Variante gemäß Fig. 4 gültig. Der Testschalter S kann durch die Überwachungsvorrichtung 1 angesteuert werden.

Ein DC-Isolationsfehler kann detektiert werden, indem ein hochohmiger Widerstand R zwischen einem der Zwischenkreis-Anschlüsse ZK-, ZK+ und das Erdpotential GND geschaltet wird und jeweils ein Gleichspannungsanteil der Isolationsspannung Uᵢₛₒ zwischen einem der Zwischenkreis-Anschlüsse ZK+, ZK- und dem Erdpotential GND vor und nach dem Schalten des hochohmigen Widerstands R ermittelt wird. Das Verhältnis dieser zwei Gleichstromanteile) zueinander lässt einen Rückschluss auf die Höhe des Isolationswiderstandes R_{isoDC} zu. Je hochohmiger der Isolationswiderstand R_{isoDC} ist, desto stärker wird durch das Einschalten des hochohmigen Widerstands R das Potential am Zwischenkreis-Anschluss ZK+, ZK- gegen das Erdpotential GND verschoben. Je größer das Verhältnis der Isolationsspannungen Uᵢₛₒ zueinander, desto größer der DC Isolationswiderstand R_{isoDC}.

Um bei der Variante gemäß Fig. 2 eine ausreichende Geschwindigkeit und Stromfestigkeit zu erreichen, ist es vorteilhaft, wenn ein im Allstrom Fehlerstrom-Detektor vorgesehener Schalter durch einen Halbleiterschalter ersetzt oder ergänzt wird, um den Testschalter S zu realisieren. Bei allen Varianten wird vor und nach dem Schalten des hochohmigen Widerstands R ein Gleichspannungsanteil der Isolationsspannung Uᵢₛₒ zwischen einem der Zwischenkreis-Anschlüsse ZK+, ZK- und den Erdpotential GND ermittelt.

Für eine kombinierte Isolationsüberwachung von DC-Isolationsfehlern und AC-Isolationsfehlern kann nun bevorzugt folgender Ablauf einer Routine herangezogen werden:
1. Prüfung, ob ein DC Isolationsfehler vorliegt
2. falls ein DC Isolationsfehler vorliegt, Wiederholung der Prüfung
3. falls kein DC Isolationsfehler vorliegt, Schalten des Wechselrichters 2 in den Netzbetrieb oder den Netzersatzbetrieb
4. Prüfung ob ein DC-oder AC Isolationsfehler vorliegt. Dies erfolgt gemäß dem zuvor beschriebenen Abläufen in zyklischer/serieller Weise mit der Testtaktrate.

Schritt 4 kann vorgesehen sein, wenn entsprechend einer Vorgabe während des Netzersatzbetriebs im IT-Netz kontinuierlich AC- und DC Isolationsfehler überprüft werden müssen. Bei Detektion eines AC- oder DC-Isolationsfehlers - also einem zu geringen AC-Isolationswiderstand und/oder DC-Isolationswiderstand R_{isoDC} kann -der Wechselrichter 2 entsprechend abgeschaltet werden.

## Patentansprüche

1. Verfahren zur Bestimmung eines AC-Isolationswiderstands (R_{isoAC}) zwischen den AC-Anschlüssen (AC1, AC2) eines Wechselrichters (2) und einem Erdpotential (GND), wobei zwischen DC-Anschlüssen (DC1, DC1) des Wechselrichters (2) eine DC-Spannung (Ue) anliegt und zwischen AC-Anschlüssen (AC1, AC2) des Wechselrichters (2) eine AC-Spannung (ua) anliegt, wobei die DC-Anschlüsse (DC1, DC1) mit einer DC-Energiequelle (3) verbunden sind und wobei in einem Netzersatzbetrieb (NE) die AC-Anschlüsse (AC1, AC2) mit einer AC-Energiesenke (4) verbunden sind, um Energie von der DC-Energiequelle (2) an die AC-Energiesenke (4) zu übertragen, **dadurch gekennzeichnet, dass** im Netzersatzbetrieb (NE) ein Isolationstest (I) durchgeführt wird, wobei aus einer zwischen einem der Zwischenkreis-Anschlüsse (ZK+, ZK-) und dem Erdpotential (GND) oder einem Zwischenkreis-Mittelpunkt (ZKm) und dem Erdpotential (GND) anliegenden Isolationsspannung (Uᵢₛₒ), vorzugsweise dem Wechselspannungsanteil der Isolationsspannung (Uᵢₛₒ), und einer zwischen dem Zwischenkreis-Anschluss (ZK+, ZK-) und dem Erdpotential (GND) oder dem Zwischenkreis-Mittelpunkt (ZKm) und dem Erdpotential (GND) befindlichen Isolationsimpedanz (Zᵢₛₒ) ein zwischen einem AC-Anschluss (AC1, AC2) und dem Erdpotential (GND) fließender AC-Fehlerstrom (i_{fAC}) ermittelt wird, **dass** eine Phasenabweichung (Δϕ) zwischen einem AC-Phasenwinkel (ϕ_{AC}) der AC-Spannung (ua) und einem Fehlerstromphasenwinkel (ϕ_{ifAC}) des AC-Fehlerstroms (i_{fAC}) berechnet wird **und dass** aus der Phasenabweichung (Δϕ) der AC-Isolationswiderstand (R_{isoAC}) berechnet wird.

2. Verfahren nach Anspruch 1, **dadurch gekennzeichnet, dass** der Isolationstest (I) mehrfach, vorzugsweise zyklisch, mit einer Testtaktrate, besonders vorzugsweise mit einer Testtaktrate im Sekundenbereich, wiederholt wird.

3. Verfahren nach Anspruch 1 oder 2, **dadurch gekennzeichnet, dass** die Isolationsimpedanz (Ziso) durch eine parasitäre DC-Kapazität (C_{isoDC}) oder durch eine parasitäre DC-Kapazität (C_{isoDC}) und einen parallelen DC-Isolationswiderstand (R_{isoDC}) angenähert wird.

4. Verfahren nach einem der Ansprüche 1 bis 3, **dadurch gekennzeichnet, dass** während des Isolationstests (I) ein Testsignal mit einer Testfrequenz (f) größer einer AC-Frequenz (f_{AC}) der AC-Spannung (ua) auf die AC-Spannung (ua) aufmoduliert wird.

5. Verfahren nach einem der Ansprüche 1 bis 4, **dadurch gekennzeichnet, dass** bei Überschreitung einer Fehlerstromschwelle durch den AC-Fehlerstrom (I_{fAC}) und/oder bei Unterschreitung einer Isolationswiderstandsschwelle des AC-Isolationswiderstand (R_{isoac}) der Wechselrichter (4) in einen Fehlerstrombetrieb geschaltet und/oder zumindest teilweise abgeschaltet wird.

6. Verfahren nach einem der Ansprüche 1 bis 5, **dadurch gekennzeichnet, dass** ein Netzbetrieb (NB) des Wechselrichters (2) vorgesehen ist, wobei beim Schalten vom Netzersatzbetrieb (NE) in den Netzbetrieb (NB) die AC-Anschlüsse (AC1, AC2) des Wechselrichters (2) von der AC-Energiesenke (4) getrennt und/oder mit einem Energieversorgungsnetz verbunden werden, um Energie von der DC-Energiequelle (2) in das Energieversorgungsnetz zu übertragen, **und dass** im Netzbetrieb (NB) der Isolationstest (I) ausgesetzt ist.

7. Verfahren nach einem der Ansprüche 1 bis 6, **dadurch gekennzeichnet, dass** ein DC-Isolationsfehler detektiert wird, indem ein hochohmiger Widerstand zwischen einem Zwischenkreis-Anschluss (ZK+, ZK-) und das Erdpotential (GND) geschaltet wird, **dass** je ein Gleichspannungsanteil der Isolationsspannung (Uᵢₛₒ) zwischen einem der Zwischenkreis-Anschlüsse (ZK+, ZK-) und den Erdpotential (GND) vor und nach dem Schalten des hochohmigen Widerstands ermittelt wird, **und dass** ein Verhältnis der jeweils ermittelten Isolationsspannungen (Uᵢₛₒ) ermittelt wird und aus dem Verhältnis auf einen DC-Isolationsfehler geschlossen wird.

8. Überwachungsvorrichtung (1) zur Ermittlung eines AC-Isolationswiderstands (R_{isoAC}) zwischen AC-Anschlüssen (AC1, AC2) eines Wechselrichters (2) und einem Erdpotential (GND), wobei DC-Anschlüsse (DC1, DC1) des Wechselrichters (2) mit einer DC-Energiequelle (3) verbindbar sind und in einem Netzersatzbetrieb (NE) AC-Anschlüsse (AC1, AC2) des Wechselrichters (2) mit einer AC-Energiesenke (4) verbindbar sind, wobei die Überwachungsvorrichtung (1) eine Fehlerstromermittlungseinheit (10) umfasst, welche ausgestaltet ist, aus einer zwischen einem der Zwischenkreis-Anschlüsse (ZK+, ZK-) und dem Erdpotential (GND) oder einem Zwischenkreis-Mittelpunkt (ZKm) und dem Erdpotential (GND) anliegenden Isolationsspannung (Uᵢₛₒ), vorzugsweise dem Wechselspannungsanteil der Isolationsspannung (Uᵢₛₒ), und einer zwischen dem Zwischenkreis-Anschluss (ZK+, ZK-) und dem Erdpotential (GND) oder dem Zwischenkreis-Mittelpunkt (ZKm) und dem Erdpotential (GND) befindlichen Isolationsimpedanz (Zᵢₛₒ) einen zwischen einem AC-Anschluss (AC1, AC2) und einem Erdpotential (GND) fließenden AC-Fehlerstrom (i_{fAC}) zu ermitteln, **dadurch gekennzeichnet, dass** die Überwachungsvorrichtung (1) eine Berechnungseinheit (11) umfasst, welche ausgestaltet ist, eine Phasenabweichung (Δϕ) zwischen einem AC-Phasenwinkel (ϕ_{AC}) der AC-Spannung (ua) und einem Fehlerstromphasenwinkel (ϕ_{ifAC}) des AC-Fehlerstroms (i_{fAC}) zu berechnen und aus der Phasenabweichung (Δϕ) den AC-Isolationswiderstand (R_{isoAC}) zu berechnen.

9. Überwachungsvorrichtung (1) nach Anspruch 8, **dadurch gekennzeichnet, dass** eine Spannungsmesseinheit (12) vorgesehen ist, welche ausgestaltet ist eine zwischen einem der Zwischenkreis-Anschlüsse (ZK+, ZK-) und dem Erdpotential (GND) anliegende Isolationsspannung (Uᵢₛₒ), vorzugsweise den Wechselspannungsanteil der Isolationsspannung (Uᵢₛₒ) zu messen, **und dass** die Fehlerstromermittlungseinheit (10) ausgestaltet ist, den AC-Fehlerstrom (f_{AC}) aus der Isolationsspannung (Uᵢₛₒ), vorzugsweise dem Wechselspannungsanteil der Isolationsspannung (Uᵢₛₒ) und einer zwischen den Zwischenkreis-Anschlüssen (ZK+, ZK-) und dem Erdpotential (GND) befindlichen Isolationsimpedanz (Zᵢₛₒ) zu berechnen.

10. Anordnung aus einem Wechselrichter (2) und einer Überwachungsvorrichtung (1) nach einem der Ansprüche 8 bis 9.

## Claims

1. Method for determining an AC insulation resistance (R_{isoAC}) between the AC connections (AC1, AC2) of an inverter (2) and a ground potential (GND), wherein a DC voltage (Ue) is applied between DC connections (DC1, DC1) of the inverter (2), and an AC voltage (ua) is applied between AC connections (AC1, AC2) of the inverter (2), wherein the DC connections (DC1, DC1) are connected to a DC power source (3), and wherein, in emergency standby operation (NE), the AC connections (AC1, AC2) are connected to an AC energy sink (4) in order to transmit energy from the DC energy source (2) to the AC energy sink (4), **characterized in that,** in emergency standby operation (NE), an insulation test (I) is performed, wherein an AC fault current (i_{fAC}) flowing between an AC connection (AC1, AC2) and the ground potential (GND) is determined from an insulation voltage (Uᵢₛₒ), preferably the AC voltage component of the insulation voltage (Uᵢₛₒ), present between one of the intermediate circuit connections (ZK+, ZK-) and the ground potential (GND) or an intermediate circuit midpoint (ZKm) and the ground potential (GND), and from an insulation impedance (Zᵢₛₒ) between the intermediate circuit connection (ZK+, ZK-) and the ground potential (GND) or the intermediate circuit midpoint (ZKm) and the ground potential (GND), **in that** a phase shift (Δϕ) between an AC phase angle (ϕ_{AC}) of the AC voltage (ua) and a fault current phase angle (ϕ_{ifAC}) of the AC fault current (i_{fAC}) is calculated, **and that** the AC insulation resistance (R_{isoAC}) is calculated from the phase shift (Δϕ).

2. Method according to claim 1, **characterized in that** the insulation test (I) is repeated several times, preferably cyclically, with a test cycle rate, particularly preferably with a test cycle rate in the range of seconds.

3. Method according to claim 1 or 2, **characterized in that** the insulation impedance (Zᵢₛₒ) is approximated by a parasitic DC capacitance (C_{isoDC}) or by a parasitic DC capacitance (C_{isoDC}) and a parallel DC insulation resistance (R_{isoDC}).

4. Method according to one of claims 1 through 3, **characterized in that,** during the insulation test (I), a test signal with a test frequency (f) greater than an AC frequency (f_{AC}) of the AC voltage (ua) is modulated onto the AC voltage (ua).

5. Method according to one of claims 1 through 4, **characterized in that,** when a fault current threshold is exceeded by the AC fault current (I_{fAC}) and/or when an insulation resistance threshold of the AC insulation resistance (R_{isoAC}) is undershot, the inverter (4) is switched to a fault current operation and/or at least partially switched off.

6. Method according to one of claims 1 through 5, **characterized in that** a mains operation (NB) of the inverter (2) is provided, wherein, while switching from emergency standby operation (NE) to mains operation (NB), the AC connections (AC1, AC2) of the inverter (2) are separated from the AC energy sink (4) and/or connected to an energy supply network in order to transmit energy from the DC energy source (2) to the energy supply network, **and that** the insulation test (I) is not run during mains operation (NB).

7. Method according to one of claims 1 through 6, **characterized in that** a DC insulation fault is detected by connecting a high-ohmic resistor between an intermediate circuit connection (ZK+, ZK-) and the ground potential (GND), **in that** a DC voltage component of the insulation voltage (Uᵢₛₒ) between one of the intermediate circuit connections (ZK+, ZK-) and the ground potential (GND) is determined before and after connecting the high-ohmic resistor, **and that** a ratio of the insulation voltages (Uᵢₛₒ) is determined, and a DC insulation fault is inferred from the ratio.

8. Monitoring device (1) for determining an AC insulation resistance (R_{isoAC}) between AC connections (AC1, AC2) of an inverter (2) and a ground potential (GND), wherein DC connections (DC1, DC1) of the inverter (2) can be connected to a DC power source (3), and, in an emergency standby operation (NE), AC connections (AC1, AC2) of the inverter (2) can be connected to an AC energy sink (4), wherein the monitoring device (1) comprises a fault current detection unit (10) which is configured to determine an AC fault current (i_{fAC}), flowing between an AC connection (AC1, AC2) and a ground potential (GND), from an insulation voltage (Uᵢₛₒ), preferably the AC voltage component of the insulation voltage (Uᵢₛₒ), present between one of the intermediate circuit connections (ZK+, ZK-) and the ground potential (GND) or an intermediate circuit midpoint (ZKm) and the ground potential (GND), and from an insulation impedance (Zᵢₛₒ) between the intermediate circuit connection (ZK+, ZK-) and the ground potential (GND) or the intermediate circuit midpoint (ZKm) and the ground potential (GND), **characterized in that** the monitoring device (1) comprises a calculation unit (11) which is configured to calculate a phase shift (Δϕ) between an AC phase angle (ϕ_{AC}) of the AC voltage (ua) and a fault current phase angle (ϕ_{ifAC}) of the AC fault current (i_{fAC}), and to calculate the AC insulation resistance (R_{isoAC}) from the phase shift (Δϕ).

9. Monitoring device (1) according to claim 8, **characterized in that** a voltage measuring unit (12) is provided which is configured to measure an insulation voltage (Uᵢₛₒ), preferably the AC voltage component of the insulation voltage (Uᵢₛₒ), present between one of the intermediate circuit connections (ZK+, ZK-) and the ground potential (GND), **and that** the fault current detection unit (10) is configured to calculate the AC fault current (f_{AC}) from the insulation voltage (Uᵢₛₒ), preferably the AC voltage component of the insulation voltage (Uᵢₛₒ), and from an insulation impedance (Zᵢₛₒ) between the intermediate circuit connections (ZK+, ZK-) and the ground potential (GND).

10. Arrangement of an inverter (2) and a monitoring device (1) according to one of claims 8 through 9.

## Revendications

1. Procédé permettant de déterminer une résistance d'isolement CA (R_{isoAC}) entre les connexions CA (AC1, AC2) d'un onduleur (2) et un potentiel de terre (GND), dans lequel une tension CC (Ue) est appliquée entre des connexions CC (DC1, DC1) de l'onduleur (2) et une tension CA (ua) est appliquée entre des connexions (AC1, AC2) de l'onduleur (2), dans lequel les connexions CC (DC1, DC1) sont connectées à une source d'énergie CC (3) et dans lequel, lors d'une opération de secours d'urgence (NE), les connexions CA (AC1, AC2) sont connectées à un puits d'énergie CA (4) afin de transmettre de l'énergie depuis la source d'énergie CC (2) au puits d'énergie CA (4), **caractérisé en ce qu'**un test d'isolement (I) est effectué lors de l'opération de secours d'urgence (NE), dans lequel un courant de défaut CA (i_{fAC}) circulant entre une connexion CA (AC1, AC2) et le potentiel de terre (GND) est déterminé à partir d'une tension d'isolement (Uᵢₛₒ) appliquée entre l'une des connexions de circuit intermédiaire (ZK+, ZK-) et le potentiel de terre (GND) ou un noyau de circuit intermédiaire (ZKm) et le potentiel de terre (GND), de préférence à partir de la composante de tension alternative de la tension d'isolement (Uᵢₛₒ), et d'une impédance d'isolement (Zᵢₛₒ) se trouvant entre la connexion de circuit intermédiaire (ZK+, ZK-) et le potentiel de terre (GND) ou le noyau de circuit intermédiaire (ZKm) et le potentiel de terre (GND), **en ce qu'**un déphasage (Δϕ) entre un angle de phase CA (ϕ_{AC}) de la tension CA (ua) et un angle de phase de courant de défaut (ϕ_{ifAC}) du courant de défaut CA (i_{fAC}) est calculé, **et en ce que** la résistance d'isolement CA (R_{isoAC}) est calculée à partir du déphasage (Δϕ).

2. Procédé selon la revendication 1, **caractérisé en ce que** le test d'isolement (I) est répété plusieurs fois, de préférence cycliquement, à une fréquence de cycle de test, de manière particulièrement préférée à une fréquence de cycle de test située dans la plage des secondes.

3. Procédé selon la revendication 1 ou 2, **caractérisé en ce que** l'impédance d'isolement (Ziso) est approximée par une capacité CC (C_{isoDC}) parasite ou par une capacité CC (C_{isoDC}) parasite et une résistance d'isolement CC (R_{isoDC}) parallèle.

4. Procédé selon l'une des revendications 1 à 3, **caractérisé en ce que,** lors du test d'isolement (I), un signal de test d'une fréquence de test (f) supérieure à une fréquence CA (f_{AC}) de la tension CA (ua) est modulé sur la tension CA (ua).

5. Procédé selon l'une des revendications 1 à 4, **caractérisé en ce que,** en cas de dépassement par le haut d'un seuil de courant de défaut par le courant de défaut CA (I_{fAC}) et/ou en cas de dépassement par le bas d'un seuil de résistance d'isolement de la résistance d'isolement CA (R_{isoac}), l'onduleur (4) est commuté en mode de courant de défaut et/ou au moins partiellement désactivé.

6. Procédé selon l'une des revendications 1 à 5, **caractérisé en ce qu'**une opération secteur (NB) de l'onduleur (2) est prévue, dans lequel, lors de la commutation de l'opération de secours d'urgence (NE) à l'opération secteur (NB), les connexions CA (AC1, AC2) de l'onduleur (2) sont déconnectées du puits d'énergie CA (4) et/ou connectées à un réseau d'opération en énergie afin de transmettre de l'énergie depuis la source d'énergie CC (2) au réseau d'opération en énergie, **et en ce que** le test d'isolement (I) est interrompu en opération secteur (NB).

7. Procédé selon l'une des revendications 1 à 6, **caractérisé en ce qu'**un défaut d'isolement CC est détecté du fait qu'une résistance de valeur ohmique élevée est commutée entre une connexion de circuit intermédiaire (ZK+, ZK-) et le potentiel de terre (GND), **en ce qu'**une composante de tension continue de la tension d'isolement (Uᵢₛₒ) est déterminée entre l'une des connexions de circuit intermédiaire (ZK+, ZK-) et le potentiel de terre (GND) avant et après la commutation de la résistance de valeur ohmique élevée, **et en ce qu'**un rapport des tensions d'isolement (Uᵢₛₒ) respectivement déterminées est déterminé et qu'un défaut d'isolement CC est déduit du rapport.

8. Dispositif de surveillance (1) permettant de déterminer une résistance d'isolement CA (R_{isoAC}) entre des connexions CA (AC1, AC2) d'un onduleur (2) et un potentiel de terre (GND), dans lequel des connexions CC (DC1, DC1) de l'onduleur (2) peuvent être connectées à une source d'énergie CC (3) et, lors d'une opération de secours d'urgence (NE), des connexions CA (AC1, AC2) de l'onduleur (2) peuvent être connectées à un puits d'énergie CA (4), dans lequel le dispositif de surveillance (1) comprend une unité de détermination de courant de défaut (10) qui est conçue pour déterminer un courant de défaut CA (i_{fAC}) circulant entre une connexion CA (AC1, AC2) et le potentiel de terre (GND), à partir d'une tension d'isolement (Uᵢₛₒ) appliquée entre l'une des connexions de circuit intermédiaire (ZK+, ZK-) et le potentiel de terre (GND) ou un noyau de circuit intermédiaire (ZKm) et le potentiel de terre (GND), de préférence à partir de la composante de tension alternative de la tension d'isolement (Uᵢₛₒ), et d'une impédance d'isolement (Zᵢₛₒ) se trouvant entre la connexion de circuit intermédiaire (ZK+, ZK-) et le potentiel de terre (GND) ou le noyau de circuit intermédiaire (ZKm) et le potentiel de terre (GND), **caractérisé en ce que** le dispositif de surveillance (1) comprend une unité de calcul (11) qui est conçue pour calculer un déphasage (Δϕ) entre un angle de phase CA (ϕ_{AC}) de la tension CA (ua) et un angle de phase de courant de défaut (ϕ_{ifAC}) du courant de défaut CA (i_{fAC}) et pour calculer la résistance d'isolement CA (R_{isoAC}) à partir du déphasage (Δϕ).

9. Dispositif de surveillance (1) selon la revendication 8,
**caractérisé en ce qu'**il est prévu une unité de mesure de tension (12) qui est conçue pour mesurer une tension d'isolement (Uᵢₛₒ) appliquée entre l'une des connexions de circuit intermédiaire (ZK+, ZK-) et le potentiel de terre (GND), de préférence la composante de tension alternative de la tension d'isolement (Uᵢₛₒ), **et en ce que** l'unité de détermination de courant de défaut (10) est conçue pour calculer le courant de défaut CA (f_{AC}) à partir de la tension d'isolement (Uᵢₛₒ), de préférence à partir de la composante de tension alternative de la tension d'isolement (Uᵢₛₒ) et d'une impédance d'isolement (Zᵢₛₒ) se trouvant entre les connexions de circuit intermédiaire (ZK+, ZK-) et le potentiel de terre (GND).

10. Agencement constitué d'un onduleur (2) et d'un dispositif de surveillance (1) selon l'une des revendications 8 à 9.
